# EUROPEAN PATENT APPLICATION

(11) **EP 1 069 212 A1**
(43) Date of publication of application: **17.01.2001**
(21) Application number: 00305892.2
(22) Date of filing: 12.07.2000
(51) Int. Cl.: C25D 5/18, C25D 7/12, H05K 3/42

(54) **Electrochemical deposition for high aspect ratio structures using electrical pulse modulation**

(30) Priority: 12.07.1999 US 143361 P; 11.05.2000 US 569833
(71) Applicant: Applied Materials, Inc., Santa Clara, California 95054 (US)
(72) Inventor: Gandikota, Srinivas, Cupertino, CA 95014 (US); Chen, Liang-Yuh, Foster City, CA 94404 (US); Duboust, Alain, Sunnyvale, CA 94086 (US); Cheung, Robin, Cupertino, CA 95014 (US); Neo, Siew, Santa Clara, CA 95051 (US); Carl, Daniel, Pleasanton, CA 94566 (US)
(74) Representative: Allard, Susan Joyce

(57) **Abstract**

Apparatus and method for electrochemically depositing a metal into a high aspect ratio structure on a substrate are provided. The method comprises: applying a constant current density over the substrate for a first time period; applying a constant reverse voltage over the substrate for a second time period; and repeating the first and second steps to fill the structure. In one embodiment, the constant current density is between about 5 mA/cm² and about 40 mA/cm² and is applied for a duration between about 0.1 second and about 20 seconds, and the constant reverse voltage is between about -5V and about -80V and is applied for a duration between about 0.02 second and about 3 seconds. After the structure has been filled, a constant current density is applied over the substrate to deposit a metal layer over the substrate. The apparatus comprises: an electrochemical deposition cell having a cathode and an anode; and a power supply electrically connected to the cathode and the anode,-the power supply adapted to selectively apply a constant reverse voltage over the substrate and a constant current density over the substrate during an electroplating process.

## Description

The present invention relates to electro-chemical deposition or electroplating of a metal onto a substrate. More particularly, the invention relates to a method for electrochemical deposition of a metal into high aspect ratio structures on a substrate.

Sub-quarter micron, multi-level metallization is one of the key technologies for the next generation of ultra large scale integration (ULSI). The multilevel interconnects that lie at the heart of this technology require planarization of interconnect features formed in high aspect ratio apertures, including contacts, vias, lines and other features. Reliable formation of these interconnect features is very important to the success of ULSI and to the continued effort to increase circuit density and quality on individual substrates and die.

As circuit densities increase, the widths of vias, contacts and other features, as well as the dielectric materials between them, decrease to less than 250 nanometers, whereas the thickness of the dielectric layers remains substantially constant, with the result that the aspect ratios for the features, *i.e.,* their height divided by width, increases. Many traditional deposition processes, such as physical vapor deposition (PVD) and chemical vapor deposition (CVD), have difficulty filling structures where the aspect ratio exceed 4:1, and particularly where it exceeds 10:1. Therefore, there is a great amount of ongoing effort being directed at the formation of void-free, nanometer-sized features having high aspect ratios wherein the ratio of feature height to feature width can be 4:1 or higher. Additionally, as the feature widths decrease, the device current remains constant or increases, which results in an increased current density in the feature.

Elemental aluminum (A1) and its alloys have been the traditional metals used to form lines and plugs in semiconductor processing because of aluminum's perceived low electrical resistivity, its superior adhesion to silicon dioxide (SiO₂), its ease of patterning, and the ability to obtain it in a highly pure form. However, aluminum has a higher electrical resistivity than other more conductive metals such as copper, and aluminum also can suffer from electromigration leading to the formation of voids in the conductor.

Copper and its alloys have lower resistivities than aluminum and significantly higher electromigration resistance as compared to aluminum. These characteristics are important for supporting the higher current densities experienced at high levels of integration and increased device speed. Copper also has good thermal conductivity and is available in a highly pure state. Therefore, copper is becoming a choice metal for filling sub-quarter micron, high aspect ratio interconnect features on semiconductor substrates.

Despite the desirability of using copper for semiconductor device fabrication, choices of fabrication methods for depositing copper into very high aspect ratio features, such as a 4:1 aspect ratio via having a width of 0.35µ or less, are limited. As a result of these process limitations, plating, which had previously been limited to the fabrication of lines on circuit boards, is just now being used to fill vias and contacts on semiconductor devices.

Metal electroplating is generally known and can be achieved by a variety of techniques. A typical method generally comprises physical vapor depositing a barrier layer over the feature surfaces, physical vapor depositing a conductive metal seed layer, preferably copper, over the barrier layer, and then electroplating a conductive metal over the seed layer to fill the structure/feature. Finally, the deposited layers and the dielectric layers are planarized, such as by chemical mechanical polishing (CMP), to define a conductive interconnect feature.

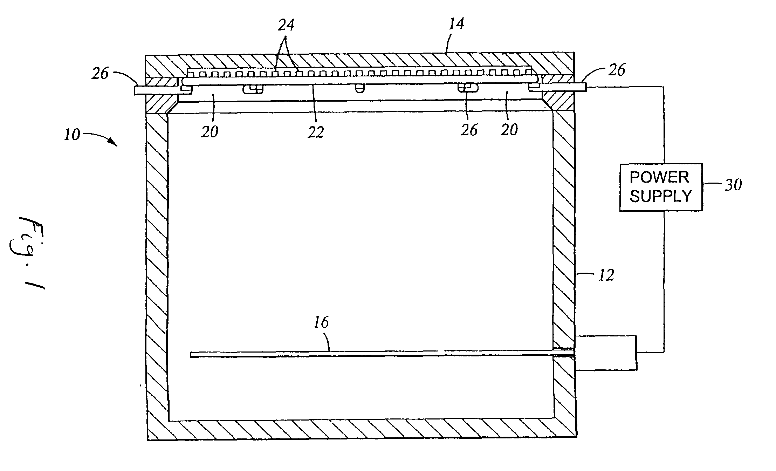

Electroplating or electrochemical deposition is being projected as an economical and viable solution for future copper interconnect needs. Figure 1 is a cross sectional view of a simplified typical fountain plater 10. Generally, the fountain plater 10 includes an electrolyte container 12 having a top opening, a substrate holder 14 disposed above the electrolyte container 12, an anode 16 disposed at a bottom portion of the electrolyte container 12 and a contact ring 20 contacting the substrate 22. A plurality of grooves 24 are formed in the lower surface of the substrate holder 14. A vacuum pump (not shown) is coupled to the substrate holder 14 and communicates with the grooves 24 to create a vacuum condition capable of securing the substrate 22 to the substrate holder 14 during processing. The contact ring 20 comprises a plurality of metallic or semi-metallic contact pins 26 distributed about the peripheral portion of the substrate 22 to define a central substrate plating surface. The plurality of contact pins 26 extend radially inwardly over a narrow perimeter portion of the substrate 22 and contact a conductive seed layer of the substrate 22 at the tips of the contact pins 26. A power supply 30 is electrically connected to the anode 16 and to the pins 26 thereby providing an electrical bias to the substrate 22. The substrate 22 is positioned above the cylindrical electrolyte container 12 and electrolyte flow impinges perpendicularly on the substrate plating surface during operation of the cell 10.

The electroplating process is typically carried out by applying a constant current density across the substrate plating surface. For example, a constant current density of about 40mA/cm2 is applied across the substrate plating surface to cause deposition thereon. Since the deposition rate is generally a function of the current density applied over the substrate plating surface, the current density is typically increased, typically greater than 40mA/cm2, to provide faster deposition and increase throughput.

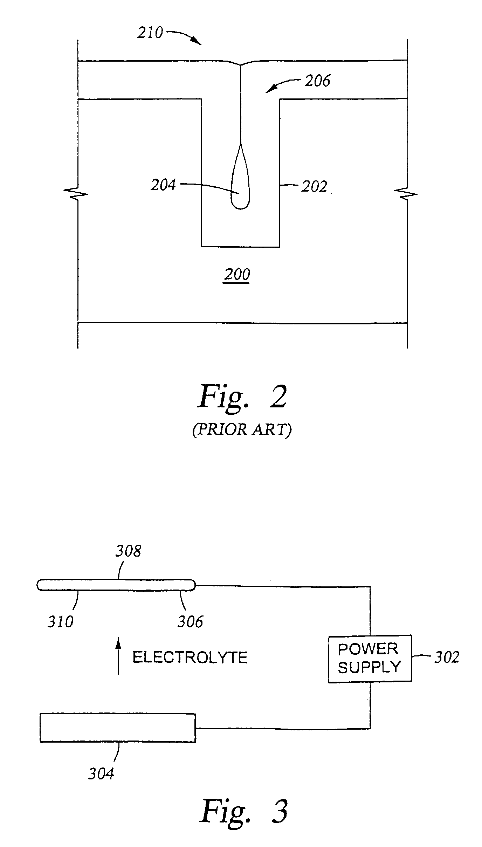

One particular problem encountered in current electroplating processes is that the currently practiced electroplating processes have not been able to provide void-free or seam-free fill of high aspect ratio structures. Figure 2 illustrates a typical deposition result of a high aspect ratio feature on a substrate 200 wherein the mouth/opening 206 of the structure 202 pinches off due to overhang or excess deposition of copper at the mouth/opening of the structure. It has been observed that the deposition 210 tends to grow much faster at the mouth or opening of the structure and pinch off the mouth/opening of the structure, leaving a void 204 inside the structure 202. The pinch off is accelerated by an increase of the current densities during electroplating, thereby causing even larger voids. It has also been observed that voids are also formed in the interconnect features due to grain mismatches from the deposition growth.

Therefore, there is a need for a method for electrochemical deposition of a metal into high aspect ratio structures on a substrate that provides void-free or seam-free fill of high aspect ratio structures.

The invention generally provides a method for electrochemical deposition of a metal into high aspect ratio structures on a substrate that provides void-free or seam-free fill of high aspect ratio structures.

One aspect of the invention provides a method for electrochemically depositing a metal into a high aspect ratio structure on a substrate, comprising: applying a constant current density over the substrate for a first time period; applying a constant reverse voltage over the substrate for a second time period; and repeating the first and second steps to fill the structure. Preferably, the constant current density is between about 5 mA/cm² and about 40 mA/cm² and is applied for a duration between about 0.1 second and about 20 seconds, and the reverse voltage is between about -15V and about -25V and is applied for a duration between about 0.02 second and about 3 seconds. Preferably, after the structure has been filled, a constant current density is applied over the substrate to deposit a metal layer over the substrate.

Another aspect of the invention provides an initial reverse voltage or reverse current pulse that removes the overhang or excess deposition of the seed layer at the opening or mouth of the interconnect feature. The initial reverse pulse also creates a gradient of the additives residing on the surface of the copper seed layer, and also smoothes out a rough seed layer surface. The substrate is then electroplated utilizing the waveform according to the invention.

Another aspect of the invention provides an initial forward current density pulse that repairs or patches the seed layer. The substrate is then electroplated utilizing the waveform according to the invention.

Another aspect of the invention the waveform according to the invention is to provide a deposition-etch-deposition (dep-etch-dep) periodic cycle that removes non-planar deposition surfaces resulting from bottom-up growth, particular at the location of the interconnect features. The dep-etch-dep process is also useful for filling interconnect features.

Another aspect of the invention provides an apparatus comprising: an electrochemical deposition cell having a cathode and an anode; and a power supply electrically connected to the cathode and the anode, the power supply adapted to selectively apply a constant reverse voltage over the substrate and a constant current density over the substrate during an electroplating process.

The advantages achieved by the present invention include: more tolerance on the copper seed coverage and copper seed morphology, a wider process window that prevents pinch-off of opening and better throughput than DC plating only because the invention allows higher-current density operation without void formation in the interconnect structures.

So that the manner in which the above recited features, advantages and objects of the present invention are attained and can be understood in detail, a more particular description of the invention, briefly summarized above, may be had by reference to the embodiments thereof which are illustrated in the appended drawings, provided by way of example.

It is to be noted, however, that the appended drawings illustrate only typical embodiments of this invention and are therefore not to be considered limiting of its scope, for the invention may admit to other equally effective embodiments.

Figure 1 is a cross sectional view of a simplified typical fountain plater.

Figure 2 illustrates a typical deposition result of a high aspect ratio feature wherein the mouth/opening of the structure pinches off due to overhang or excess deposition of copper at the mouth/opening of the structure.

Figure 3 is a schematic diagram showing the electrical connections of the invention.

Figure 4 is an electrical waveform showing the output of the power supply to the substrate according to the invention.

Figure 5 illustrates one embodiment of the electroplating sequence according to the invention.

The invention generally provides a method for electrochemical deposition of a metal into high aspect ratio structures on a substrate that provides void-free and seam-free fill of high aspect ratio structures. The invention is preferably practiced using an electrochemical deposition cell, such as the Electra™ Cu ECP system, available from Applied Materials, Inc., Santa Clara, CA. A detailed description of an electrochemical deposition system is provided in commonly assigned and copending U.S. Patent Application 09/289,074, entitled "Electro-chemical Deposition System", filed on April 8, 1999, which is hereby incorporated by reference in its entirety.

Figure 3 is a schematic diagram showing the electrical connections of the invention. A power supply 302 is connected to the anode 304 and the cathode 306 of the electroplating system. The cathode 306 electrically contacts a seed layer 310 on the substrate plating surface 308. The power supply 302 preferably includes a control circuit that switches between a constant current operation and a constant voltage operation. The control circuit of the power supply 302 also controls the polarity of the output. The power supply 302 preferably also includes a switching circuit that is programmable to produce a variety of output waveforms, such as an output waveform comprising repetitions of a constant current output for a first duration and a constant voltage output for a second duration. The invention contemplates utilizing a variety of power supply designs that are capable of producing such output waveforms and is not limited to any particular power supply design.

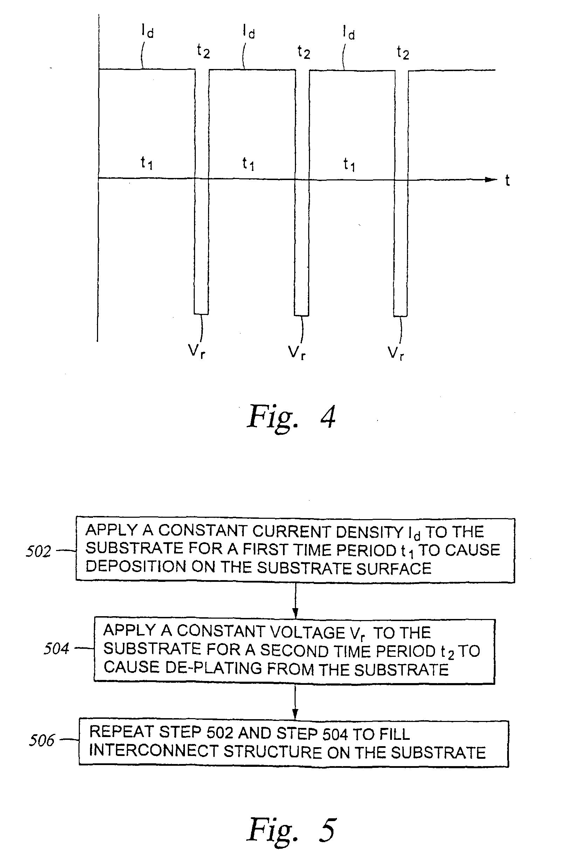

Figure 4 is an electrical waveform showing the output of the power supply to the substrate according to the invention. Figure 5 illustrates one embodiment of the electroplating sequence according to the invention. According to one embodiment of the invention, a constant current density, I_{d}, is applied to the substrate for a first time period, t₁, to cause deposition onto the substrate plating surface (step 502), including the surfaces of the interconnect structures, and then a constant voltage of reverse polarity, Vᵣ, is applied to the substrate for a second time period, t₂, to cause de-plating or etching of the deposited metal (step 504). The time periods t₁ and t₂ together make up one cycle of the electrical waveform applied to the substrate. The cycle is repeated (step 506) for a determined number of times to completely fill the interconnect structure. After the structures on the substrate have been filled, a constant current density I_{d} is typically applied to the substrate for a selected duration to deposit the metal layer to a desired thickness.

Preferably, the constant current density I_{d} applied to the substrate is between about 5 mA/cm² and about 80 mA/cm², even more preferably at between about 5 mA/cm² and about 40 mA/cm². The first time period t₁ has a duration preferably between about 0.1 second and about 20 seconds. The constant voltage of reverse polarity, Vᵣ, applied to the substrate is preferably a high voltage between about -5V and about -80V in magnitude, more preferably between about -15V and about -25V. The second time period, t₂, has a duration preferably between about 0.02 second and 3 seconds, more preferably between about 0.2 second and 0.4 second.

An alternative embodiment of the invention utilizes a reverse constant current density over the substrate instead of a constant reverse voltage for the dissolution (*i.e.*, etch) period. Preferably, a reverse constant current density between about 5 mA/cm² and about 100 mA/cm² for a duration preferably between about 0.02 second and 3 seconds.

Another alternative embodiment of the invention provides an initial forward pulse of constant current density applied to the substrate surface to patch or repair the seed layer. It has been observed that the copper seed layer may have discontinuities, poor step coverage or uneven distribution due to limitations of the. physical vapor deposition process. The forward current density pulse patches the copper seed layer to provide an improved nucleation surface for the electroplating process. To further improve the uniformity of the seed layer, a reverse constant voltage can be applied to remove the overhang or excess deposition of the seed layer at the mouth or opening of the interconnect feature.

The inventors have discovered that a short (*i.e.*, less than 0.5 seconds) reverse voltage is useful for removing the overhang or excess deposition at the opening/mouth of the interconnect feature while keeping most of the deposition within the interconnect structure. Also, it is preferred to utilize a high reverse voltage (*i.e.*, greater than -10V) to de-plate the overhang or excess deposition at the mouth/opening of the interconnect feature. Thus, the de-plating cycle of the invention preferably comprises a high constant reverse voltage for short duration.

The above process parameters are preferably practiced with a copper electroplating bath having multi-components comprising copper electrolyte and additives such as suppressers and brighteners/accelerators. A detailed description of the electroplating chemistry, particularly the composition of the electrolyte and additives, is provided in commonly assigned and copending U.S. Patent Application No. 09/245,780, entitled "Electrodeposition Chemistry for Improved Filling of Apertures," filed on February 5, 1999, which is hereby incorporated by reference in its entirety.

The copper electrolyte provides the metal ions to be deposited while the suppressers and the suppressers and brighteners/accelerators control the deposition profile. The suppressers adsorb on the wafer surfaces and inhibit or reduce copper deposition in the areas where suppressers have been adsorbed. Brighteners or accelerators compete with suppresser molecules for adsorption sites and accelerate copper growth in the areas where brighteners/accelerators have been adsorbed. The activities of suppressers and accelerators depend on various parameters such as temperature, pH of bath and chloride concentration in the bath, and all of these parameters directly or indirectly effect the polarization of these additives.

The suppressers and accelerators tend to reside over the surfaces in the interconnect structures (*i.e.*, vias and trenches) as soon as the substrate comes into contact with the electroplating bath. Since the molecular dimensions of accelerators are much smaller than that of suppressers, the accelerators can diffuse through the electrolyte faster than the suppressers. The inventors have discovered that the pulse width (*i.e.*, duration) of the negative voltage is an important parameter for achieving a voidless and seamless filling utilizing the forward constant current density and reverse constant voltage electrochemical deposition sequence because the inhibition time to achieve bottom up growth is increased as the duration of the negative pulse (*i.e.,* the reverse voltage for de-plating) is increased. Particularly, a short negative voltage pulse less than 3 seconds provides voidless and seamless deposition in the interconnect features. The de-plating process is preferably carried out utilizing high voltages (*i.e.,* between about -5V and about -80V, more preferably between about -15V and about -25V) at short pulse widths (*i.e.,* between about 0.02 second and about 3 seconds, more preferably between about 0.2 second and 0.4 second).

The inventors have also discovered that the forward current density and reverse voltage waveform according to the invention is useful for planarizing the resulting surface of the deposition after the interconnect structure has been filled. A non-planar upper surface typically results from electrochemical deposition that provides bottom-up growth, particularly over the location of the interconnect features. According to this aspect of the invention, the electrical waveform output of the power supply comprising a forward constant current for deposition and a reverse constant voltage for de-plating is continued after the interconnect feature has been completely filled to provide a substantially planar upper surface of the deposited layer. This output wave form can be continued for a desired duration to achieve a desired thickness of the deposited metal over the substrate surface.

The initial forward current density and reverse voltage cycle is also useful for creating a gradient of the additives residing on the surface of the seed layer. It has been observed that the additives such as suppressers and accelerators compete for nucleation sites on the surfaces of the seed layer. The inventors have discovered that application of the initial forward current density and reverse voltage cycle creates a gradient of the additives residing on the surface of the seed layer and balances the distribution of the additives. Thus, a controlled deposition profile is provided by application of the forward constant current and reverse constant voltage waveform.

Another benefit of the initial forward current density and reverse voltage cycle is that a seed layer is patched and evened out for improved deposition results. The copper seed layer, which is typically deposited by a physical vapor deposition method, typically exhibits some overhang or excess deposition at the mouth/opening of the interconnect feature. The seed layer may also have some discontinuities, poor step coverage, and uneven seed layer distribution. An initial forward current pulse repairs the discontinuities, poor step coverage and unevenness of the seed layer. The initial reverse voltage removes the overhang/excess deposition at the mouth/opening of the interconnect feature. Thus, the deposition profile is improved because the uniformity of the see layer has been improved.

In another aspect of the invention the waveform according to the invention provides a deposition-etch-deposition (dep-etch-dep) periodic cycle that removes non-planar deposition surfaces resulting from bottom-up growth, particularly at the location of the interconnect features. The above described forward constant current and reverse constant voltage waveform can be used as the dep-etch-dep process. Preferably, the ratio of deposition to etch is between about 3:1 and about 5:1. The dep-etch-dep process is also useful for filling interconnect features.

### Example

The following is an example of a substrate having high aspect ratio interconnect features deposited utilizing the method according to the invention. Before subjecting the substrate to the electroplating process according to the invention, a barrier layer having about 250Å thickness comprising TaN is deposited over the substrate utilizing well known processing parameters for physical vapor deposition. Preferably, the barrier layer is deposited using the Vectra® IMP chamber from Applied Materials, Inc., Santa Clara, CA. A copper seed layer having about 2000Å thickness is deposited over the barrier layer, also utilizing well known processing parameters for physical vapor deposition. The substrate is then transferred to an electroplating cell, such as the Electra™ Cu ECP system, available from Applied Materials, Inc., Santa Clara, CA, and a copper layer is deposited on the substrate utilizing the electroplating method according to the invention.

The composition of the electroplating bath comprised 0.85M copper sulfate with a pH of about 1.75 after adding suppressers and accelerators. The temperature of the bath was maintained between about 15°C to about 25°C. The substrate is preferably biased with a forward plating current density as the substrate is loaded into the electrolyte. The waveform according to the invention is applied to the substrate with a forward constant current density between about 10 mA/cm² and about 40 mA/cm² for a duration between about 4 seconds and about 16 seconds, and a reverse constant voltage of about -20V for about 0.3 seconds. The lower current density (10 mA/cm²) requires a longer duration (16 seconds) to plate the desired amount per cycle while a higher current density (40 mA/cm2) requires a shorter (4 seconds) to plate the same desired amount of copper. The cycle was repeated for a total of six times to complete the electrochemical deposition process. Scanning electron microscope (SEM) and focused ion beam (FIB) analysis of substrates processed according to the above example shows that the electrochemical deposition method according to the invention provides void-free and seam-free filling of high aspect ratio structures.

While the foregoing is directed to the preferred embodiment of the present invention, other and further embodiments of the invention may be devised without departing from the basic scope thereof, and the scope thereof is determined by the claims that follow.

## Claims

1. A method for electrochemically depositing a metal into a high aspect ratio structure on a substrate, the method comprising:
(a) applying a constant current density over the substrate for a first time period;
(b) applying a constant reverse voltage over the substrate for a second time period; and
(c) repeating steps (a) and (b) to fill the structure.

2. The method of claim 1, wherein the first period has a duration between about 0.1 second and about 20 seconds.

3. The method of claim 1 or claim 2, wherein the second period has a duration between about 0.02 second and about 3 seconds.

4. The method of any one of claims 1 to 3, further comprising applying an initial reverse polarity power over the substrate before step (a).

5. The method of claim 4, wherein the initial reverse power comprises a constant reverse voltage.

6. The method of claim 4, wherein the initial reverse power comprises a constant reverse current.

7. A method for electrochemically depositing a metal into a high aspect ratio structure on a substrate, the method comprising:
(a) applying a constant reverse voltage over the substrate for a first time period;
(b) applying a constant current density over the substrate for a second time period; and
(c) repeating steps (a) and (b) to fill the structure.

8. The method of any one of claims 1 to 7, further comprising applying a constant current density over the substrate to deposit a metal layer over the substrate.

9. The method of any one of claims 1 to 8, wherein the constant current density is between about 5 mA/cm² and about 40 mA/cm².

10. The method of any one of claims 1 to 9, wherein the constant reverse voltage is between about -5 V and about -80 V.

11. The method of any one of claims 7 to 10, wherein the first period has a duration between about 0.02 second and about 3 seconds.

12. The method of any one of claims 7 to 11, wherein the second period has a duration between about 0.1 second and about 20 seconds.

13. The method of any one of claims 7 to 12, further comprising applying an initial constant current density pulse over the substrate before step (a).

14. The method of claim 13, wherein the initial constant current density pulse comprises a current density between about 5 mA/cm² and 80 mA/cm² for between about 0.1 second and about 20 seconds.

15. An apparatus for electrochemically depositing a metal into a high aspect ratio structure on a substrate, the apparatus comprising:
an electrochemical deposition cell having a cathode and an anode; and
a power supply electrically connected to the cathode and the anode, the power supply being adapted to selectively apply a substantially constant reverse voltage over the substrate and a substantially constant current density over the substrate during an electroplating process.

16. The apparatus of claim 15, further comprising:
a controller connected to control an output of the power supply.

17. The apparatus of claim 16, wherein the controller selectively switches the output of the power supply between a constant current mode and a constant voltage mode.

18. The apparatus of claim 17, wherein the constant current mode comprises a constant current density between about 5 mA/cm² and 80 mA/cm² for between about 0.1 second and about 20 seconds.

19. The apparatus of claim 17 or claim 18, wherein the constant voltage mode comprises a constant reverse voltage between about -5 V and about -80 V for between about 0.02 second and about 3 seconds.
